Europäisches Patentamt

European Patent Office

Office européen des brevets

(11) Publication number: **0 333 240**
**A1**

## (12) EUROPEAN PATENT APPLICATION

(21) Application number: **89200269.2**

(22) Date of filing: **06.02.89**

(51) Int. Cl.4: **H01J 37/09 , H01J 37/141**

(30) Priority: **12.02.88 NL 8800344**

(43) Date of publication of application:
**20.09.89 Bulletin 89/38**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Bölger, Bouwe**
**c/o INT. OCTROOIBUREAU B.V. Prof.**
**Holstlaan 6**
**NL-5656 AA Eindhoven(NL)**
Inventor: **Slingerland, Hendrik Nicolaas**
**c/o INT. OCTROOIBUREAU B.V. Prof.**
**Holstlaan 6**
**NL-5656 AA Eindhoven(NL)**

(74) Representative: **Scheele, Edial François et al**
**INTERNATIONAAL OCTROOIBUREAU B.V.**
**Prof. Holstlaan 6**
**NL-5656 AA Eindhoven(NL)**

(54) Charged particle beam apparatus.

(57) A superconductive screening is provided around, for example, the specimen chamber or optical spaces to be considered therefor in a charged particle beam apparatus for screening from external or internal stray magnetic fields or magnetic inhomogeneities. By constructing the said screenings from a ceramic superconductive material with terminal seals having only a small aperture for the passage of a particle beam, a mutual influencing of the optical elements can also be strongly reduced.

## Charged particle beam apparatus

The invention relates to a charged a charged particle beam apparatus comprising a particle source, a particle optical system, a specimen table accommodated in a specimen chamber and having a screening built up from a superconductive material.

Such an apparatus is disclosed in US 4.214,166.

With the resolving power of such apparatuses advancing, inter alia due to improved optical systems, the apparatuses become more and more sensitive to optical interferences caused in particular by magnetic fields. Superconductive screenings provided to mitigate this require too much space, in particular also a result of the necessary thermal insulation thereof. As a result of the comparatively large dimensions of the screenings, they can often not be positioned optimally, so that either the optical system or the screening is not optimum.

It is the object of the invention to reduce the said drawbacks and for that purpose a charged particle beam apparatus of the type mentioned in the opening paragraph is characterized according to the invention in that at least a part of the particle optical system and/or of the specimen chamber is surrounded by an externally cooled screening of a ceramic superconductive material.

By thus screening optical spaces which are sensitive to stray magnetic fields or optical spaces in the proximity of which comparatively strong stray magnetic fields may occur, the resolving power of the apparatus may be increased and measurements performed with such an apparatus become more reliable and better reproducible. As stray magnetic fields may occur, for example, the following fields. Stray fields which penetrate from without into an optical space of the apparatus, for example, the earth's magnetic field, or stray fields of electric motors, and the like.

Stray fields of optical elements of the apparatus which penetrate axially into an optical space or the specimen chamber where the said fields are undesired. Disturbances in lens fields in a field space which result from magnetic inhomogeneities in a space outside the optical space and influence the lens field via the stray fields.

In a preferred embodiment the specimen chamber of an apparatus constructed as a scanning electron microscope is enclosed by a superconductive screening. Such a screening may extend in the direction of the electron source to near an electron optical element which can generate magnetic fields which are not desired for the specimen chamber and on a side facing the said element may comprise only a small aperture for the passage of the electron beam.

In a further preferred embodiment an optical space within the optical system together with the optical elements which are active there is surrounded by a superconductive screening which is closed, for example, both on a source side and on a specimen side, with only an adapted aperture for a particle beam. In particular the said screening may also comprise the specimen chamber and may be closed entirely on the side of the specimen.

The superconductive material preferably is a layer of a superconductive ceramic material which associates a comparatively high transition temperature with a comparatively high specific heat in the superconductive phase. In particular a layer of this material is provided on a carrier of a readily heat-conducting material, for example, copper. The carrier then is, for example, in a good thermal contact with a cooling device accomodated at any rate outside the superconductive screening, for example, a liquid-nitrogen reservoir or a cold-gas refrigerator for temperatures to below, for example, approximately 80 K.

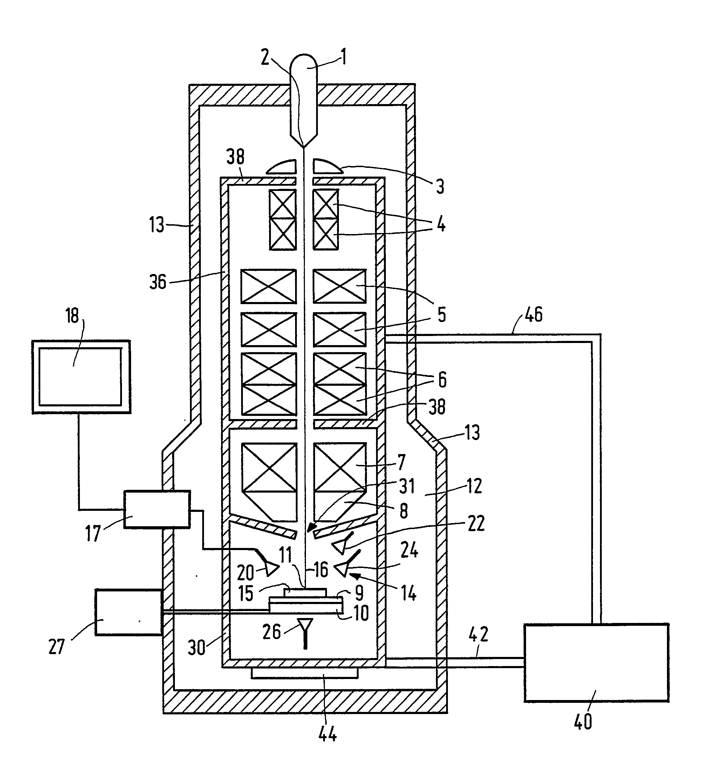

A few embodiments according to the invention will now be described in greater detail, by way of example, with reference to the drawing.

A scanning electron microscope as shown in the sole Figure of the drawing comprises an electron source 1 with an emission element 2, for example, a field emission source or a semiconductor source, and an anode 3, a beam alignment system 4, a condensor lens 5, a beam scanning system 6, an exit lens 7 with poleshoes 8 and a specimen table 9 with an adjusting mechanism 10. All these elements are accomodated in a housing 12 having a vacuum-tight housing wall 13, which housing also includes a specimen chamber 14. A specimen 15 is scanned in a scanning electron microscope by an electron beam 16 with a current strength of $10^{-11}$ A and an energy corresponding to 1 kV. The electron beam is focused on the object by means of a system of lenses to form a small spot 11, for example, $50 \times 10^{-10}$ m. Scanning is customarily according to a television line pattern. Radiation which is generated by interaction of the electron beam and the specimen is detected and the detection signal is applied via a detection device 17 to a television monitor 18 operating in synchronism with the specimen scanning. As a result of this a point-to-point relationship is formed between the specimen and the image. The enlargement is given by the ratio between the monitor image and the scanned specimen surface and may be varied, for example, between 10 and 200,000.

The signal to be used for the image formation may be obtained by detecting, for example, reflected electrons, secondary emission electrons, transmitted electrons and absorbed electrons, but also X-ray radiation or cathode luminescent radiation generated in the specimen. For several of these radiations it is of importance at what angle the radiation leaves the specimen or what wavelength of the generated electromagnetic radiation is measured. Accomodated in the specimen chamber are, for example, a detector 20 for the detection of electrons reflected at the specimen, a detector 22 for the detection of luminescent radiation generated in the specimen, a detector 24 for the detection of secondary electrons and a detector 26 for the detection of electrons passing the specimen.

According to the invention space 14 with the various detectors is closed by a superconductive screening 30 which is closed entirely with the exception of a small aperture for the passage of the electron beam. In a practical embodiment leadthroughs for detector lines for specimen table control will be passed through the screening, but these, too, may be kept extremely small. The superconductive screening comprises a layer of a superconductive material provided, for example, by vapour deposition or sputtering on a carrier of a material having a good thermal conductivity. In this manner the specimen chamber is protected from external stray fields, for example, from an electric motor 27 for moving the specimen and for the lens field of the exit lens 7. A motor placed in the vacuum housing may be surrounded with a superconductive screening in a corresponding manner. A screening from the last-mentioned field can also be realised by providing the poleshoes 8 with a superconductive material isolated therefrom thermally. For screening optical spaces of the apparatus a screening 36 which also consists of a layer of superconductive material may be provided between the wall 13 of the apparatus and the optical elements. For example, the beam alignment system 4 may be screened by this, for example, also from fields of succeeding optical elements having interfering influence or for screening the source of particles from stray fields of the beam alignment. Such a screening may optionally comprise partitions 38 for the mutual screening of the said elements. The screening may also comprise both the optical space and the specimen chamber in which, again optionally, partitions may be provided. The screenings are cooled by a cooling device 40 which is connected to the carrier of the superconductive material via a heat conductor 42. For a good contact an extra contact plate 44 is mounted against a lower side of the specimen chamber screening. Such an extra contact plate may also be used in the form of a cylinder to improve the thermal contact between a further heat conductor 46 and the screening 36 around the optical space.

A screening according to the invention for a particle apparatus in which one of the optical elements constitutes a multipole lens has a particularly favourable effect. Such multipole lenses customarily comprise magnet coils which are situated in a plane parallel to the optical axis of the system, for example, in a generated surface of a cylinder assumed therearound. As a result of this the said elements have a comparatively large external stray field and field interference in the lens field can hence easily occur via the said stray field by magnetic interferences in an area covered by the stray field. On the other hand the problem of an extra dipole field caused by a non-rotationally symmetrical difference in magnetic permeability of the surrounding material often occurs with these multipole lenses. This field interference can also be avoided by placing the actual coils of the system in a superconductive sleeve.

Although the invention has been described hereinbefore substantially with reference to an electron microscope, the invention is by no means restricted thereto. The invention may also be used, for example, for chip inspection devices as described in EP 196 958, in ion beam apparatus, for example, as described in G 13 13 84 182 or WO 86/02774 and the like. With reference to the description hereinbefore the screenings in such apparatus can simply be adapted to the geometry and optical properties of the apparatus and will hence not be further described.

## Claims

1. A charged particle beam apparatus having a particle source, a particle optical system and a specimen table accomodated in the specimen chamber and having a screening built up from a superconductive material, characterized in that at least a part of the particle optical system and/or of the specimen chamber is surrounded by an externally cooled screening of a ceramic superconductive material.

2. A charged particle beam apparatus as claimed in Claim 1, characterized in that it is constructed as a scanning electron microscope the specimen chamber of which is enclosed by a superconductive screening protecting the chamber from stray magnetic fields.

3. A charged particle beam apparatus as claimed in Claim 2, characterized in that the screening of the specimen chamber extends in the direction of a condensor lens of the particle optical system and on a side facing the said lens is closed with a pinhole aperture for the passage of the electron beam to protect the field of said lens.

4. A charged particle beam apparatus as claimed in Claim 1, characterized in that the particle optical system comprises a superconductive screening which screens from external stray magnetic fields.

5. A charged particle beam apparatus as claimed in Claim 1 or 4, characterized in that the particle optical system comprises a multipole lens device which is enclosed by a cylindrical superconductive screening having an aperture at each axial end.

6. A charged particle beam apparatus as claimed in any of the preceding Claims, characterized in that the superconductive screening is present in a vacuum housing and enclosed the particle optical system with the specimen chamber.

7. A charged particle beam apparatus as claimed in any of the preceding Claims, characterized in that the superconductive material is formed by a layer of a ceramic superconductive material which is provided on a readily heat-conducting carrier.

8. A charged particle beam apparatus as claimed in Claim 7, characterized in that, for cooling the carrier of the superconductive screening, it is in a readily heat-conducting contact with a cooling device.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| Y | US-A-3 916 201 (HERRMANN et al.)<br>* Figure 1; column 3, lines 21-26; column 4, lines 30-39 * | 1 | H 01 J 37/09<br>H 01 J 37/141 |
| A | | 2-6 | |
| Y | PROCEEDINGS OF THE 18TH INTERNATIONAL CONFERENCE ON LOW TEMPERATURE PHYSICS, Kyoto, 1987, Japanese Journal of Applied Physics, vol. 26, supplement 26-3, pages 1211-1212, Tokyo, JP; T. GOTO et al.: "Preparation of high Tc oxide superconducting filaments using the method of solution spinning"<br>* Paragraph 1 * | 1 | |
| A | DE-A-2 726 195 (SIEMENS AG)<br>* Figures 1,2; page 6, line 21 .- page 7, line 3; page 7, line 26 - page 11, line 19 * | 1-6 | |
| A | FR-A-2 397 715 (SIEMENS AG)<br>* Claim 1 * | 1-5 | TECHNICAL FIELDS SEARCHED (Int. Cl.4) |
| A | US-A-3 821 554 (ZERBST et al.)<br>* Abstract * | 1-5 | H 01 J 37/00<br>H 01 L 39/00 |
| A | DE-A-1 614 693 (SIEMENS AG)<br>* Figures; claims * | 1-5,8 | |
| A | PHYSICA STATUS SOLIDI (a), vol. 78, 1982, pages 447-453; E. KNAPEK et al.: "New results on superconducting Nb-Sn sinter material applied for electron microscope lenses"<br>* Abstract * | 1-5 | |

The present search report has been drawn up for all claims

| Place of search | Date of completion of the search | Examiner |
|---|---|---|
| THE HAGUE | 07-06-1989 | SCHAUB G.G. |

EPO FORM 1503 03.82 (P0401)